# EUROPÄISCHE PATENTSCHRIFT

(11) **EP 0 484 699 B1**
(45) Veröffentlichungstag und Bekanntmachung des Hinweises auf die Patenterteilung: **18.08.1993**
(21) Anmeldenummer: 91117531.3
(22) Anmeldetag: 15.10.1991
(51) Int. Cl.: F01L 1/16, C23C 16/26, C23C 14/06

(54) **Reibpaarung und Verfahren zu ihrer Herstellung**
Friction pairing and its method of manufacture
Accouplement de frottement et son procédé de fabrication

(30) Priorität: 05.11.1990 DE 9015179 U; 21.08.1991 DE 4127639
(43) Veröffentlichungstag der Anmeldung: 13.05.1992
(73) Patentinhaber: Repenning, Detlev, Dr., D-23569 Lübeck (DE); Mordike, Barry Leslie, Prof. Dr., D-37520 Osterode (DE)
(72) Erfinder: Repenning, Detlev, Dr., D-23569 Lübeck (DE); Mordike, Barry Leslie, Prof. Dr., D-37520 Osterode (DE)
(74) Vertreter: Gramm, Werner, Prof., Dipl.-Ing.

(56) Entgegenhaltungen:
- EP-A- 0 435 312
- DE-A- 3 712 205
- GB-A- 2 128 637
- US-A- 4 974 498
- PATENT ABSTRACTS OF JAPAN vol. 11, no. 330 (M-636)22. Mai 1987 & JP-A-62 111 106 ( HITACHI LTD ) 8. November 1985

## Beschreibung

Die Erfindung betrifft eine Reibpaarung, bestehend aus der Nockenlauffläche einer Nockenwelle und einer Gegenläuferschicht, die auf das Grundmaterial eines z. B. als Tassenstößel, Schlepp- oder Kipphebel ausgebildeten Gegenläufers aufgebracht ist.

Eine derartige Reibpaarung läßt sich dem Dokument JP-A-62111106 entnehmen. Bei der hier offenbarten Reibpaarung kann die Nockenlauffläche oder die Gegenläuferschicht 0,5 bis 10 Gew.% Kohlenstoff, 5 bis 70 Gew.% Chrom und als Rest Eisen aufweisen, wobei mehr als 80 % des Kohlenstoffanteils Carbid enthält.

Die Erfindung betrifft ferner ein Verfahren zur Herstellung einer derartigen Reibpaarung.

Das Dokument DE-A-37 12 205 offenbart ein Verfahren zur Herstellung von Reibschichten, insbesondere für Otto- und Dieselmotorenteilen, die nach dem Plasma-CVD-Verfahren als diamantähnliche Kohlenstoffschichten hergestellt werden.

Die überlicherweise zur Ventilsteuerung eingesetzte Materialpaarung von z. B. Tassenstößeln und Nockenwellen aus Einsatzstahl und Schalenharguß im nitrierten oder unnitrierten Zustand weist meist hohe Reibwerte und dementsprechend auch einen hohen Verschleiß auf. Als nachteilig erweist sich ferner, daß die angestellten Federkräfte nicht weiter erhöht werden können, was aber zur präziseren Ventilsteuerung wünschenswert wäre.

Der Erfindung liegt die Aufgabe zugrunde, eine Reibpaarung der eingangs beschriebenen Art mit reduzierten Reibwerten und geringerem Verschleiß sowie ein Verfahren zu deren Herstellung zu entwickeln.

Die Aufgabe wird hinsichtlich der Reibpaarung erfindungsgemäß dadurch gelöst, daß die Gegenläuferschicht eine nanodisperse, amorphe Metall-Kohlenstoffschicht ist, die zu 50 bis 90 At% aus Kohlenstoff, 2 bis 25 At% aus Wasserstoff und Rest aus Metall besteht, wobei der Kohlenstoff zum Teil in Diamantbindungsstruktur vorliegt.

Der besondere Vorteil der erfindungsgemäß gestalteten Gegenläuferschicht liegt einerseits in ihrem geringen Reibkoeffizienten im Kontakt mit metallischen Gleitpartnern und andererseits darin, daß das Motoröl im Gleitkontakt nicht katalytisch zersetzt wird zu Sikkativen.

Die die Gegenläuferschicht bildende Kohlenstoffschicht kann erfindungsgemäß nach verschiedenen Verfahren hergestellt werden. Möglich ist eine Herstellung nach dem Plasma-CVD-Verfahren, mit dem sich Ion-Carbon (i-C) oder Amorphous-Carbonhydrogen (a-CH) herstellen lassen, die kein Metall enthalten. Möglich ist aber auch eine Herstellung nach dem PVD-Verfahren, wie z. B. Sputter- oder ARC-Technologie, wobei gleichzeitig Metalle verdampft und in die zu bildende Schicht eingebaut werden, die auch als Metal-Carbonhydrogen-Schichten (Me-CH) bezeichnet werden. Der Kohlenstoff bildet dabei mit den Metallen Metalcarbide aus, so daß sich eine erhöhte Temperaturbeständigkeit der Schicht ergibt.

Das Metall der Gegenläuferschicht kann Titan, Niob, Tantal, Chrom, Molybdän, Eisen und/oder Wolfram sein. Vorzugsweise aber werden die Metalle Wolfram, Tantal und Titan in die Gegenläuferschicht eingebaut und zwar entweder einzeln oder aber als Legierungsbestandteile von Mischlegierungsverdamperplatten.

Die Gegenläuferschicht weist vorzugsweise eine Dicke von 2 bis 12 Mikrometer, eine Härte (H) von > 2000 HV 0.01, eine glasartige Struktur und/oder eine keine scharfen Spitzen aufweisende Oberflächenrauhigkeit (Rz) zwischen 0,8 und 3 Mikrometer auf.

Die im wesentlichen kohlenstoffhaltigen Schichten der Gegenläuferschicht werden vorzugsweise mit zumindest einer Zwischenschicht auf das Grundmaterial aufgebracht. Hierzu eignen sich besonders Chrom- oder chromhaltige Schichten. Wählt man als Zwischenschicht eine Kombination Chrom/Chromnitrid, so ergibt sich hieraus nicht nur der Vorteil einer erhöhten Haftfestigkeit für die amorphe, diamantähnliche Kohlenstoffschicht, sondern noch der zusätzliche Vorteil, daß mit dieser sehr haftfesten Zwischenschicht eine tribologisch günstig wirkende "Gleit- und Verschleißreserve" geschaffen wird. Sollte nämlich nach einer gewissen Gebrauchsdauer die aufliegende amorphe Schicht teilweise verschlissen oder verletzt sein, wirkt die Chromnitridschicht verschleiß- oder ölzersetzungshemmend.

Statt Chromnitrid lassen sich für die Zwischenschicht auch andere, ähnlich wirkende Metalle verwenden wie z. B. Titannitrid, Titancarbit, Cirkoniumnitrid und dergleichen.

Die Dicke der Zwischenschicht beträgt vorzugsweise 0,1 bis 5 Mikrometer.

Um von vornherein einen günstigen Schmiertascheneffekt zu erzielen, ist es vorteilhaft, wenn vor dem Aufbringen der Gegenläuferschicht bzw. der Zwischenschicht die zu beschichtende Fläche des Gegenläufers mit einem Strukturschliff mit einer Rauhtiefe von 0,5 bis 10 Mikrometer versehen wird. Alternativ kann auch eine sogenannte Orangenhaut an der Oberfläche erzeugt werden.

Eine besonders vorteilhafte Reibpaarung zeichnet sich erfindungsgemäß dadurch aus, daß die Nockenlauffläche eine feinstkörnige ledeburitische Schicht aufweist, die im Laserumschmelzverfahren gehärtet ist.

Die Dicke der die fertig bearbeitete Nockenlauffläche bildenden Schicht beträgt vorzugsweise 50 bis 400 Mikrometer.

Schließlich ist es vorteilhaft, wenn die die Nockenlauffläche bildende Schicht nach dem Laserumschmelzen fein geschliffen wird.

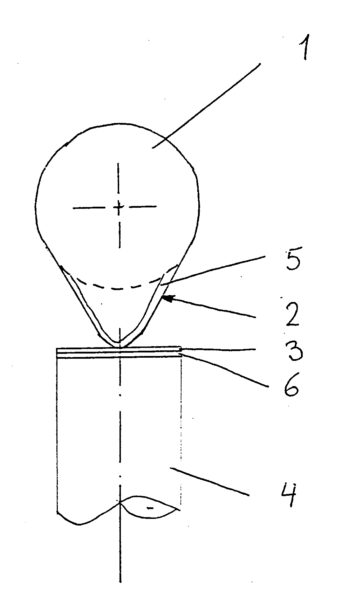

In der Zeichnung ist eine als Beispiel dienende Ausführungsform der Erfindung schematisch dargestellt.

Die Zeichnung zeigt eine Nockenwelle 1 mit einer Nockenlauffläche 2, die mit einer Gegenläuferschicht 3 eines Gegenläufers 4 zusammenwirkt.

Die Nockenlauffläche 2 wird von einer feinstkörnigen ledeburitischen Schicht 5 gebildet, die im Laserumschmelzverfahren gehärtet ist.

Die Gegenläuferschicht 3 ist eine Cerid-Schicht, die über eine Zwischenschicht 6 auf den Gegenläufer 4 aufgebracht ist, der z. B. aus 16 MnCr 5 bestehen kann.

## Patentansprüche

1. Reibpaarung, bestehend aus der Nockenlauffläche (2) einer Nockenwelle (1) und einer Gegenläuferschicht (3), die auf das Grundmaterial eines z. B. als Tassenstößel, Schlepp- oder Kipphebel ausgebildeten Gegenläufers (4) aufgebracht ist, **dadurch gekennzeichnet**, daß die Gegenläuferschicht (3) eine nanodisperse, amorphe Metall-Kohlenstoffschicht ist, die zu 50 bis 90 At% aus Kohlenstoff, 2 bis 25 At% aus Wasserstoff und Rest aus Metall besteht, wobei der Kohlenstoff zum Teil in Diamantbindungsstruktur vorliegt.

2. Reibpaarung nach Anspruch 1, **dadurch gekennzeichnet**, daß die Gegenläuferschicht (3) mit zumindest einer Zwischenschicht (6) auf das Grundmaterial aufgebracht ist.

3. Reibpaarung nach Anspruch 2, **dadurch gekennzeichnet**, daß die Zwischenschicht (6) eine chromhaltige Schicht ist.

4. Reibpaarung nach Anspruch 3, **dadurch gekennzeichnet**, daß die Zwischenschicht (6) eine kombinierte Chrom/Chromnitrid-Schicht ist.

5. Reibpaarung nach Anspruch 2, 3 oder 4, **dadurch gekennzeichnet**, daß die Dicke der Zwischenschicht (6) 0,1 bis 5 Mikrometer beträgt.

6. Reibpaarung nach einem der vorhergehenden Ansprüche, **dadurch gekennzeichnet**, daß das Metall der Gegenläuferschicht (3) Titan, Niob, Tantal, Chrom, Molybdän, Eisen und/oder Wolfram ist.

7. Reibpaarung nach Anspruch 6, **dadurch gekennzeichnet**, daß die Metalle Wolfram, Tantal und Titan einzeln in die Gegenläuferschicht (3) eingebaut sind.

8. Reibpaarung nach Anspruch 6, **dadurch gekennzeichnet**, daß die Metalle Wolfram, Tantal und Titan von Mischlegierungsverdampferplatten als Legierungsbestandteile in die Gegenläuferschicht (3) eingebaut sind.

9. Reibpaarung nach einem der vorhergehenden Ansprüche, **dadurch gekennzeichnet**, daß die Dicke der Gegenläuferschicht (3) 2 bis 12 Mikrometer beträgt.

10. Reibpaarung nach einem der vorhergehenden Ansprüche, **dadurch gekennzeichnet**, daß die Gegenläuferschicht (3) eine Härte (H) > 2000 HV 0.01 sowie eine glasartige Struktur aufweist.

11. Reibpaarung nach einem der vorhergehenden Ansprüche, **dadurch gekennzeichnet,** daß die Oberflächenrauhigkeit (Rz) der Gegenläuferschicht (3) zwischen 0,8 und 3 Mikrometer liegt und keine scharfen Spitzen aufweist.

12. Reibpaarung nach einem der vorhergehenden Ansprüche, **dadurch gekennzeichnet,** daß die Nockenlauffläche (2) eine feinstkörnige ledeburitische Schicht (5) aufweist, die im Laserumschmelzverfahren gehärtet ist.

13. Reibpaarung nach Anspruch 12, **dadurch gekennzeichnet,** daß die Dicke der die fertig bearbeiteten Nockenlauffläche (2) bildenden Schicht (5) 50 bis 400 Mikrometer beträgt.

14. Verfahren zur Herstellung einer Reibpaarung, bestehend aus der Nockenlauffläche einer Nockenwelle und einer Gegenläuferschicht, die auf das Grundmaterial eines Gegenläufers aufgebracht wird, **dadurch gekennzeichnet,** daß die Gegenläuferschicht nach dem PVD-Verfahren, wie z. B. Sputter - oder ARC-Technologie, als diamantähnliche Kohlenstoffschicht hergestellt wird, die 50 bis 90 At% Kohlenstoff, 2 bis 25 At% Wasserstoff und als Rest Metall aufweist, das durch gleichzeitige Verdampfung in die Schicht eingebaut wird und so eine Metal-Carbonhydrogen-Schicht (Me-CH) bildet.

15. Verfahren nach Anspruch 14, **dadurch gekennzeichnet,** daß die Gegenläuferschicht mit zumindest einer Zwischenschicht aufgebracht wird.

16. Verfahren nach Anspruch 14 oder 15, **dadurch gekennzeichnet,** daß vor dem Aufbringen der Gegenläuferschicht bzw. der Zwischenschicht die zu beschichtende Fläche des Gegenläufers mit einem Strukturschliff mit einer Rauhtiefe von 0,5 bis 10 Mikrometer versehen wird.

17. Verfahren nach einem der Ansprüche 14 bis 16, **dadurch gekennzeichnet,** daß als Nockenlauffläche durch Laserumschmelzen eine feinstkörnige ledeburitische Schicht erzeugt wird.

18. Verfahren nach Anspruch 17, **dadurch gekennzeichnet,** daß die die Nockenlauffläche bildende Schicht nach dem Laserumschmelzen fein geschliffen wird.

## Claims

1. Friction pairing, comprising the cam running surface (2) of a camshaft (1) and an opposing layer (3) which is applied to the base material of an opposing member (4) constructed for example as a cup-type pushrod, a drawing or tilting lever, characterized in that the opposing layer (3) is a nanodisperse amorphous metal/carbon layer which comprises from 50 to 90 At% of carbon, 2 to 25 At% of hydrogen and the remainder of metal, the carbon partially being present in a diamond bonding structure.

2. Friction pairing according to Claim 1, characterized in that the opposing layer (3) is applied to the base material with at least one intermediate layer (6).

3. Friction pairing according to Claim 2, characterized in that the intermediate layer (6) is a chromium-containing layer.

4. Friction pairing according to Claim 3, characterized in that the intermediate layer (6) is a combined chromium/chromium nitride layer.

5. Friction pairing according to Claim 2, 3 or 4, characterized in that the thickness of the intermediate layer (6) is 0.1 to 5 micrometres.

6. Friction pairing according to one of the preceding claims, characterized in that the metal of the opposing layer (3) is titanium, niobium, tantalum, chromium, molybdenum, iron and/or tungsten.

7. Friction pairing according to Claim 6, characterized in that the metals tungsten, tantalum and titanium are incorporated individually into the opposing layer (3).

8. Friction pairing according to Claim 6, characterized in that the metals tungsten, tantalum and titanium from mixed-alloy evaporator plates are incorporated into the opposing layer (3) as alloy components.

9. Friction pairing according to one of the preceding claims, characterized in that the thickness of the opposing layer (3) is 2 to 12 micrometres.

10. Friction pairing according to one of the preceding claims, characterized in that the opposing layer (3) has a hardness (H) > 2000 Vickers hardness 0.01, and has a glassy structure.

11. Friction pairing according to one of the preceding claims, characterized in that the surface roughness (Rz) of the opposing layer (3) is between 0.8 and 3 micrometres and has no sharp points.

12. Friction pairing according to one of the preceding claims, characterized in that the cam running surface (2) has an extremely fine-grain ledeburitic layer (5) which is hardened by the laser re-fusing process.

13. Friction pairing according to Claim 12, characterized in that the thickness of the layer (5) forming the cam running surface (2) which is ready machined is 50 to 400 micrometres.

14. Process for producing a friction pairing, comprising the cam running surface of a camshaft and an opposing layer which is applied to the base material of an opposing member, characterized in that the opposing layer is produced by the PVD process, such as sputter or arc technology, as a diamond-like carbon layer which has 50 to 90 At% of carbon, 2 to 25 At% of hydrogen and the remainder of metal, which is incorporated into the layer by simultaneous evaporation and thus form a metal/carbon hydrogen layer (Me/CH).

15. Process according to Claim 14, characterized in that the opposing layer is applied with at least one intermediate layer.

16. Process according to Claim 14 or 15, characterized in that before applying the opposing layer or the intermediate layer the surface of the opposing member to be coated is provided with a structural polish having a roughness depth of 0.5 to 10 micrometres.

17. Process according to one of Claims 14 to 16, characterized in that an extremely fine-grain ledeburitic layer is produced as the cam running surface by laser re-fusing.

18. Process according to Claim 17, characterized in that the layer forming the cam running surface is polished fine after laser re-fusing.

## Revendications

1. Accouplement de frottement, constitué de la piste de came (2) d'un arbre à came (1) et d'une couche (3) appartenant à un organe suiveur, rapportée sur la matière de base d'un organe suiveur (4) réalisé par exemple sous la forme d'un poussoir, d'un levier de traction ou d'un culbuteur, caractérisé en ce que la couche (3) de l'organe suiveur est une couche amorphe métal-carbone en nanodispersion, composée de 50 à 90 % en nombre d'atomes de carbone, de 2 à 25 % en nombre d'atomes d'hydrogène, le reste étant constitué de métal, le carbone présentant en partie une structure à liaisons diamant.

2. Accouplement de frottement selon la revendication 1, caractérisé en ce que la couche (3) de l'organe suiveur est rapportée sur la matière de base avec au moins une couche intermédiaire (6).

3. Accouplement de frottement selon la revendication 2, caractérisé en ce que la couche intermédiaire (6) est une couche contenant du chrome.

4. Accouplement de frottement selon la revendication 3, caractérisé en ce que la couche intermédiaire (6) est une couche combinée chrome/nitrure de chrome.

5. Accouplement de frottement selon la revendication 2, 3 ou 4, caractérisé en ce que l'épaisseur de la couche intermédiaire (6) est de 0,1 à 5 microns.

6. Accouplement de frottement selon l'une des revendications précédentes, caractérisé en ce que le métal de la couche (3) de l'organe suiveur est du titane, du niobium, du tantale, du chrome, du molybdène, du fer et/ou du tungstène.

7. Accouplement de frottement selon la revendication 6, caractérisé en ce que les métaux tungstène, tantale et titane sont installés isolément dans la couche (3) de l'organe suiveur.

8. Accouplement de frottement selon la revendication 6, caractérisé en ce que les métaux tungstène, tantale et titane sont installés en tant que composante d'alliage dans la couche (3) de l'organe suiveur à partir de plaques de vaporisation d'alliages en mélange.

9. Accouplement de frottement selon l'une des revendications précédentes, caractérisé en ce que la couche (3) de l'organe suiveur a une épaisseur de 2 à 12 microns.

10. Accouplement de frottement selon l'une des revendications précédentes, caractérisé en ce que la couche (3) de l'organe suiveur a une dureté (H) supérieure à 2000 HV 0.01, et présente une structure du type verre.

11. Accouplement de frottement selon l'une des revendications précédentes, caractérisé en ce que la rugosité de surface (Rz) de la couche (3) de l'organe suiveur est comprise entre 0,8 et 3 microns et ne présente pas de pointes aiguës.

12. Accouplement de frottement selon l'une des revendications précédentes, caractérisé en ce que la piste de came (2) présente une couche lédeburitique à grains très fins, qui est durcie par le procédé de refusion au laser.

13. Accouplement de frottement selon la revendication 12, caractérisé en ce que la couche (5) constituant la piste de came (2) présente une fois complètement ouvrée une épaisseur de 50 à 400 microns.

14. Procédé pour fabriquer un accouplement de frottement constitué par la piste de came d'un arbre à came et par une couche appartenant à un organe suiveur, qui est rapportée sur la matière de base d'un organe suiveur, caractérisé en ce que la couche de l'organe suiveur est réalisée sous la forme d'une couche de carbone analogue à du diamant selon le procédé de dépôt en phase vapeur par action physique, comme par exemple la technologie de vaporisation sous vide ou ARC, cette couche comportant 50 à 90 % en nombre d'atomes de carbone, 2 à 25 % en nombre d'atomes d'hydrogène, le reste étant du métal qui est installé par vaporisation simultanée dans la couche et constitue ainsi une couche métal-carbone hydrogène (Me-CH).

15. Procédé selon la revendication 14, caractérisé en ce que la couche de l'organe suiveur est rapportée avec au moins une couche intermédiaire.

16. Procédé selon la revendication 14 ou 15, caractérisé en ce qu'avant de rapporter la couche de l'organe suiveur ou le cas échéant la couche intermédiaire, la surface à revêtir sur l'organe suiveur est soumise à un polissage structurel avec une profondeur d'aspérités de 0,5 à 10 microns.

17. Procédé selon l'une des revendications 14 à 16, caractérisé en ce que comme piste de came on réalise une couche lédeburitique à grains très fins par refusion au laser.

18. Procédé selon la revendication 17, caractérisé en ce qu'après la refusion au laser la couche formant la piste de came est finement polie.
